# EUROPÄISCHE PATENTSCHRIFT

(11) **EP 2 642 254 B1**
(45) Veröffentlichungstag und Bekanntmachung des Hinweises auf die Patenterteilung: **25.11.2015**
(21) Anmeldenummer: 13157956.7
(22) Anmeldetag: 06.03.2013
(51) Int. Cl.: G01D 5/347

(54) **Anordnung mit einer ersten und einer zweiten Positionsmesseinrichtung**
Assembly comprising a first and a second position measuring device
Arrangement comportant un premier et un second dispositif de mesure de position

(30) Priorität: 22.03.2012 DE 102012204572
(43) Veröffentlichungstag der Anmeldung: 25.09.2013
(73) Patentinhaber: Dr. Johannes Heidenhain GmbH, 83301 Traunreut (DE)
(72) Erfinder: Holzapfel, Wolfgang,, 83119 Obing (DE); Drescher, Jörg,, 83122 Samerberg (DE); Meissner, Markus,, 83236 Übersee (DE); Joerger, Ralph,, 83278 Traunstein (DE); Musch, Bernhard,, 83624 Otterfing (DE); Kälberer, Thomas, 86529 Schrobenhausen (DE)

(56) Entgegenhaltungen:
- EP-A1- 2 006 740
- EP-A2- 1 923 672
- US-A1- 2008 098 813
- US-A1- 2011 255 096

## Beschreibung

Die vorliegende Erfindung betrifft eine Anordnung mit einer ersten und einer zweiten Positionsmesseinrichtung.

In Maschinen, die bei der Fertigung und Prüfung von Halbleiterbauelementen zum Einsatz kommen, besteht oftmals die Anforderung, Objekte präzise zu positionieren. So kann es etwa erforderlich sein, Wafer hochgenau unterhalb eines Werkzeugs einer Belichtungs- oder Inspektionseinheit zu positionieren. Der Wafer liegt dabei auf einem in sechs Freiheitsgraden beweglichen Tisch, der über einen entsprechenden Antrieb bewegt wird. Als Objekt, dessen Position hochgenau zu erfassen ist, fungiert hier demzufolge der Tisch; um diesen Tisch über den Antrieb und eine zugehörige Steuereinheit zu positionieren, ist die Erzeugung von Positionssignalen zur räumlichen Lage des Tisches mittels hochgenauer Positionsmesseinrichtungen erforderlich.

Als hochgenaue Positionsmesseinrichtungen dienen in derartigen Maschinen üblicherweise Interferometer oder aber gitterbasierte optische Positionsmesseinrichtungen. In der DE 10 2012 201 393.3 der Anmelderin wird eine Messanordnung für eine derartige Anwendung vorgeschlagen, die aus einer Kombination unterschiedlicher Positionsmesseinrichtungen besteht. So wird für die Positionsmessung entlang einer ersten, langen Hauptbewegungsachse des Objekts und zur Erfassung von Rotationsbewegungen um weitere Achsen ein Mehrachsinterferometer eingesetzt. Am Objekt ist hierbei ein Messreflektor angeordnet, der von den Messstrahlen des Mehrachsinterferometers beaufschlagt wird. Zur Positionsmessung entlang einer zweiten Hauptbewegungsachse und entlang einer dritten Achse werden gitterbasierte, interferentielle Positionsmesseinrichtungen vorgeschlagen; diese umfassen u.a. am Objekt angeordnete Maßverkörperungen in Form von Auflicht-Beugungsgittern sowie stationär demgegenüber angeordnete Reflektoren; an den Reflektoren sind weitere Beugungsgitter angeordnet, wobei die Reflektoren etwa als Durchlichtgitter-Spiegel-Einheit ausgebildet sein können. Die in den verschiedenen Positionsmesseinrichtungen eingesetzten Messreflektoren, Maßverkörperungen und Reflektoren unterliegen während der Montage und im Einsatz mechanischen sowie thermischen Belastungen und können sich hierbei auch langsam verformen. Derartige Verformungen dieser Elemente haben Messfehler bei der Positionsbestimmung zur Folge.

Zur Kompensation dieser Messfehler sind sog. Selbstkalibrierungsverfahren bekannt, über die im Betrieb oder in speziellen Kalibrierzyklen der jeweiligen Maschine die aktuellen Verformungen der entsprechenden Elemente, wie z.B. der Maßverkörperungen bzw. Reflektoren, messtechnisch erfasst und korrigiert werden. Für derartige Selbstkalibrierungsverfahren ist üblicherweise erforderlich, dass entlang der jeweiligen Erstreckungsrichtung die Maßverkörperung oder der Reflektor mittels zweier oder mehrerer Abtast- bzw. Optikeinheiten abgetastet und über die beiden Optikeinheiten Positionssignale erzeugt werden. Die Positionssignale der beiden Optikeinheiten werden dann in Differenz zueinander verschaltet, so dass aus dem resultierenden Differenzsignal anschließend in bekannter Art und Weise der konkret vorliegende, verformungsbedingte Fehler der jeweiligen Maßverkörperung bzw. des Reflektors berechnet und nachfolgend kompensiert werden kann. In Bezug auf derartige Selbstkalibrierungsverfahren sei etwa auf die Veröffentlichung "Exact wavefront reconstruction from two lateral shearing interferograms", C. Elster, I. Weingärtner in Vol. 16, No. 9, Sept 1999, J. Opt. Soc. Am. A, 2281-2285, verwiesen.

Pro Messrichtung bedeutet dies, dass für ein derartiges Selbstkalibrationsverfahren zwei Optikeinheiten zur Abtastung und Positionssignalerzeugung erforderlich sind. Dies stellt einen erheblichen Mehraufwand dar und hat desweiteren eine Vergrößerung des Bauvolumens des Gesamtsystems zur Folge.

Unabhängig von der erläuterten Selbstkalibrierungsproblematik kann es auch aus anderen Gründen erforderlich oder vorteilhaft sein, bei bestimmten Messabläufen oder Maschinenzuständen Positionen entlang einer Bewegungsrichtung redundant zu erfassen. Damit kann z.B. an bestimmten Positionen die Zahl erforderlicher sog. Abbe-Arme reduziert oder die Genauigkeit gesteigert werden.

Aus der EP 1 923 672 A2 ist eine Positionsmesseinrichtung zur Erzeugung eines Referenzimpulssignals an mindestens einer Referenzposition bekannt.

Die EP 2 006 740 A1 offenbart eine Positionsmesseinrichtung, die je zwei Sensoren für die Erfassung der Position eines Substrattisches entlang unterschiedlicher Bewegungsrichtungenx, y aufweist. Eine selektiv ausgewählte Kombination von drei dieser Sensoren wird zur Positionsbestimmung verwendet; der nicht zur Positionsbestimmung verwendete vierte Sensor kann zu Kalibrationszwecken genutzt werden.

Aufgabe der vorliegenden Erfindung ist es, eine Möglichkeit zur hochgenauen Positionserfassung eines beweglichen Objektes anzugeben, über die mit möglichst wenig Aufwand die Position des Objekts entlang unterschiedlicher Messrichtungen messtechnisch erfasst werden soll.

Diese Aufgabe wird gelöst durch eine Anordnung mit den Merkmalen des Anspruches 1.

Vorteilhafte Ausführungsformen der erfindungsgemäßen Lösungen finden sich in den abhängigen Ansprüchen.

Über die erfindungsgemäße Anordnung mit einer ersten und einer zweiten Positionsmesseinrichtung ist eine Erfassung der Position eines ersten Objekts in Bezug auf ein zweites Objekt möglich, wobei das erste und das zweite Objekt entlang mindestens zweier Messrichtungen relativ zueinander beweglich angeordnet sind. Die Positionsmesseinrichtung umfasst eine Optikeinheit, die mit einem der beiden Objekte verbunden ist und mindestens eine Lichtquelle, eine Detektoranordnung sowie weitere optische Elemente in definierter Anordnung aufweist. Ferner ist eine Maßverkörperung-Reflektor-Einheit vorgesehen, welche am anderen Objekt angeordnet ist. Diese weist mindestens zwei unterschiedlich ausgebildete Bereiche in einer Spur auf, die zur Positionserfassung mit der Optikeinheit optisch abtastbar sind, wobei über die unterschiedliche Ausbildung der Bereiche bei der Positionserfassung eine Umschaltung zwischen den verschiedenen Messrichtungen möglich ist und für jede Messrichtung mit der Optikeinheit jeweils Positionssignale bezüglich der Relativbewegung der beiden Objekte erzeugbar sind.

In einer möglichen Ausführungsform sind in den unterschiedlichen Bereichen der Spur der Maßverkörperungs-Reflektor-Einheit Messreflektoren und Maßverkörperungen angeordnet.

Hierbei können die Messreflektoren als Planspiegel und die Maßverkörperungen als Auflicht-Beugungsgitter ausgebildet sein. Vorzugsweise erfahren Strahlenbündel, die auf die unterschiedlich ausgebildeten Bereiche auftreffen unterschiedliche Umlenk- und/oder Ablenkwirkungen.

Mit Vorteil weist die Maßverkörperungs-Reflektor-Einheit mehrere parallel angeordnete Spuren auf, in denen Maßverkörperungen und/oder Messreflektoren angeordnet sind.

Es ist hierbei möglich, dass
- in einer Spur eine Maßverkörperung angeordnet ist und
- in einer weiteren Spur in einem ersten Bereich ein Messreflektor angeordnet ist und in einem zweiten Bereich eine Maßverkörperung angeordnet ist, die identisch zur Maßverkörperung in der anderen Spur ausgebildet ist.

Es kann vorgesehen werden, dass entlang der Erstreckungsrichtung der Spur ein zentraler erster Bereich in der Spur angeordnet ist und mindestens an einem Ende des ersten Bereichs ein unterschiedlich ausgebildeter zweiter Bereich in der Spur angeordnet ist.

Ferner ist es möglich, dass in der Spur ein erster Bereich angeordnet ist, der sich über den Großteil der Spur erstreckt und ein zweiter, unterschiedlich ausgebildeter Bereich in der Spur angeordnet ist, der sich lediglich über einen deutlich kleineren Bereich der Spur erstreckt.

Eine mögliche Anordnung umfasst ferner
- ein erstes Objekt, das entlang zweier orthogonaler, erster und zweiter Hauptbewegungsachsen sowie entlang einer hierzu dritten Achse beweglich angeordnet ist, wobei
   - die erste Hauptbewegungsachse als erste Messrichtung fungiert,
   - die dritte Achse als zweite Messrichtung und
   - die zweite Hauptbewegungsachse als dritte Messrichtung;
   und
- ein zweites Objekt, das stationär gegenüber dem ersten Objekt angeordnet ist, wobei die Optikeinheit am zweiten Objekt angeordnet ist
   Hierbei ist am ersten Objekt die sich entlang der zweiten Hauptbewegungsachse erstreckende Maßverkörperungs-Reflektor-Einheit angeordnet, die eine Spur mit einem ersten Bereich mit einem Messreflektor und einen zweiten Bereich mit einer Maßverkörperung umfasst, so dass bei der optischen Abtastung des ersten Bereichs Positionssignale bezüglich einer Bewegung des ersten Objekts entlang der ersten Messrichtung erzeugbar sind und bei der optischen Abtastung des zweiten Bereichs Positionssignale bezüglich einer Bewegung des ersten Objekts entlang der zweiten Messrichtung oder entlang der dritten Messrichtung erzeugbar sind.

Die Anordnung kann eine zweite Positionsmesseinrichtung umfassen, über die Positionssignale bezüglich einer Bewegung des ersten Objekts entlang der zweiten Messrichtung erzeugbar sind.

Ferner kann die Anordnung eine dritte Positionsmesseinrichtung umfassen, über die Positionssignale bezüglich einer Bewegung des ersten Objekts entlang der dritten Messrichtung erzeugbar sind.

Es ist damit möglich, dass im Fall der optischen Abtastung der Maßverkörperung im zweiten Bereich und der gleichzeitigen Erzeugung von Positionssignalen mittels der zweiten oder dritten Positionsmesseinrichtung während einer Verfahrbewegung entlang der ersten Messrichtung jeweils eine zweifache Abtastung eines Reflektors der zweiten oder dritten Positionsmesseinrichtung entlang der ersten Messrichtung erfolgt.

Hierbei kann vorgesehen werden, dass
- die Positionssignale der ersten und zweiten Positionsmesseinrichtung einer Kalibrationseinheit zuführbar sind und/oder
- die Positionssignale der ersten und dritten Positionsmesseinrichtung einer Kalibrationseinheit zuführbar sind.

Vorzugsweise ist die erste Positionsmesseinrichtung als Mehrachs-Interferometer mit vier Messstrahlen ausgebildet.

Maßgeblich an der vorliegenden Erfindung ist demzufolge, dass die Messrichtung, entlang der eine Positionserfassung mit der erfindungsgemäßen Anordnung erfolgt, nunmehr nicht durch die verwendete Abtasteinheit bzw. Optikeinheit und die darin vorgesehene Abtastoptik festgelegt wird, sondern ausschließlich durch die Ausbildung bestimmter Bereiche auf Seiten der verwendeten Maßverkörperungs-Reflektor-Einheit. Abhängig von der Relativposition der zueinander beweglichen Objekte bzw. von bestimmten Maschinenstellungen ist es dadurch möglich, zwischen verschiedenen Messrichtungen, entlang derer Positionsinformationen benötigt werden, definiert umzuschalten und zusätzliche Positionssignale bzgl. der Objektbewegung entlang der jeweiligen neuen Messrichtung zu erzeugen. Für die verschiedenen Messrichtungen kann jeweils die gleiche Optikeinheit bzw. Abtastoptik zur Positionssignalerzeugung eingesetzt werden. Es resultiert eine erhebliche Reduzierung des Aufwands für das Gesamtsystem sowie eine Verringerung des Bauvolumens.

Neben dem nachfolgend noch im Detail zu erläuternden Anwendungsfall in einer Anordnung, in der eine Selbstkalibrierung bestimmter Komponenten erforderlich ist, kann die vorliegende Erfindung selbstverständlich auch in Verbindung mit anderen Messanordnungen eingesetzt werden, bei denen eine derartige Umschaltmöglichkeit zwischen verschiedenen Messrichtungen erforderlich oder von Vorteil ist.

Weitere Einzelheiten und Vorteile der vorliegenden Erfindung seien anhand der nachfolgenden Beschreibung eines Ausführungsbeispiels in Verbindung mit den Figuren erläutert.

Es zeigt
- Figur 1a: eine stark schematisierte Darstellung einer erfindungsgemäßen Anordnung mit einer Positionsmesseinrichtung in einer ersten Ansicht (zy-Ebene);
- Figur 1b: eine stark schematisierte Darstellung der Anordnung aus Figur 1a in einer zweiten Ansicht (xy-Ebene);
- Figur 1c: eine Frontansicht der Optikeinheit aus der Anordnung der vorhergehenden Figuren;
- Figur 1d: eine Draufsicht auf die Maßverkörperungs-Reflektor-Einheit der Anordnung aus den vorhergehenden Figuren;
- Figur 1e: eine Draufsicht auf die Reflektoren der Anordnung aus den vorhergehenden Figuren;
- Figur 2a, 2b: je eine schematisierte Teildarstellung der Anordnung aus den vorhergehenden Figuren in verschiedenen Messstellungen zur Erläuterung der Messrichtungsumschaltung.

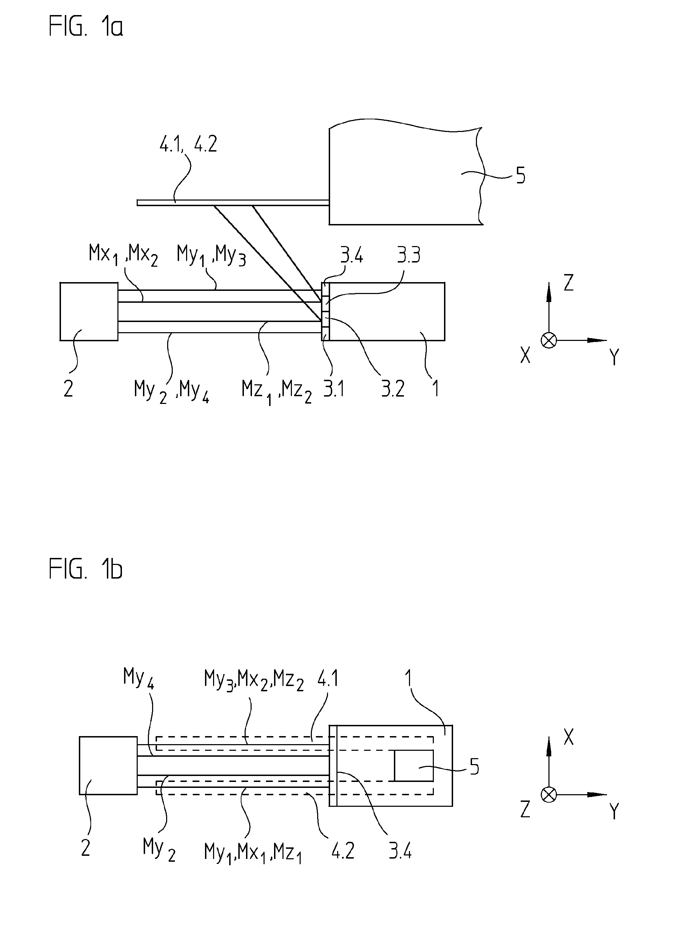

In den Figuren 1a, 1b ist eine Anordnung zur Erfassung der Position eines ersten Objekts 1 in sechs Freiheitsgraden stark schematisiert in verschiedenen Ansichten dargestellt. Das erste Objekt 1, beispielsweise ein Tisch in einer Maschine zur Halbleiterfertigung oder -inspektion, ist hierbei entlang einer ersten und zweiten Hauptbewegungsachse y, x sowie entlang einer hierzu senkrechten dritten Achse z beweglich gegenüber einem zweiten Objekt 5 angeordnet, beispielsweise einem stationären Maschinenteil. Im Folgenden sei die erste Hauptbewegungsachse y auch als erste Messrichtung bezeichnet, die dritte Achse z als zweite Messrichtung und die zweite Hauptbewegungsachse x als dritte Messrichtung.

Neben der Erfassung der linearen Objektbewegung entlang der zwei Hauptbewegungsachsen x, y und entlang der dritten Achse z ist zur hochgenauen Positionierung des Objekts 1 ferner die messtechnische Erfassung von Rotationsbewegungen des Objekts 1 um die drei verschiedenen Achsen x, y, z erforderlich, um die Position des Objekts 1 im Raum in allen sechs Freiheitsgraden zu bestimmen. Die Rotationsbewegungen des Objekts 1 um die Achsen x, y, z werden nachfolgend als Rx-, Ry- und Rz-Bewegung bezeichnet.

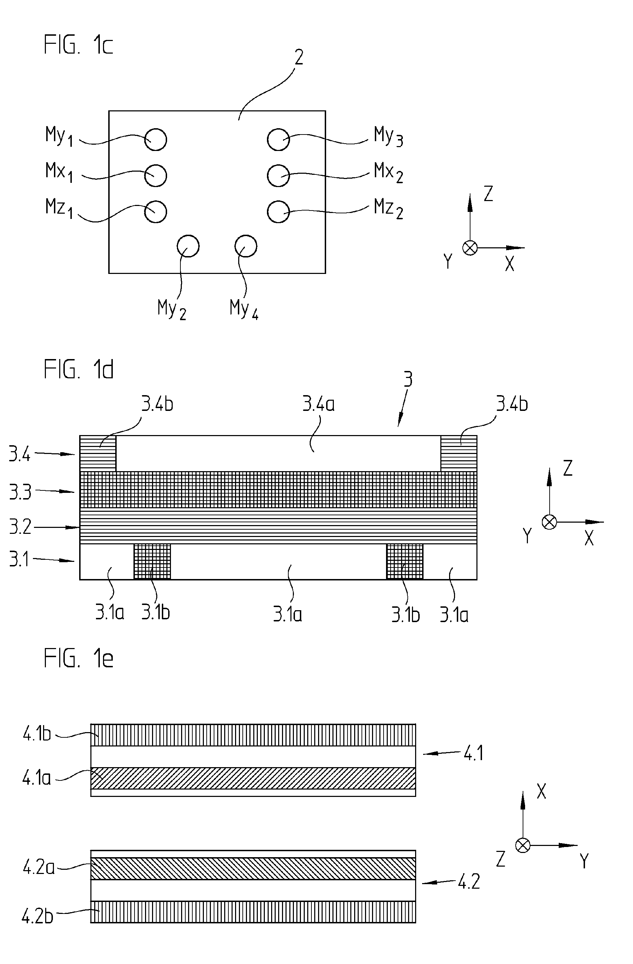

Zur Erfassung aller sechs Freiheitsgrade des bewegbaren ersten Objektes 1 dienen mehrere Positionsmesseinrichtungen, die geeignet zu einem Gesamtsystem kombiniert werden, wie dies in der DE 10 2012 201 393.3 grundsätzlich bereits beschrieben ist; der Offenbarungsgehalt der DE 10 2012 201 393.3 sei daher ausdrücklich in die vorliegende Anmeldung einbezogen. Die Positionsmesseinrichtungen umfassen einerseits eine Optikeinheit 2 sowie Reflektoren 4.1,4.2, die im vorliegenden Beispiel mit dem zweiten Objekt 5, d.h. mit dem stationären Maschinenteil, verbunden bzw. gekoppelt sind. In der Optikeinheit 2 sind hierbei eine Lichtquelle, eine Detektoranordnung sowie weitere optische Elemente in definierter Anordnung vorgesehen, die allesamt nicht in den Figuren gezeigt sind. Alternativ zur unmittelbaren Anordnung der Lichtquelle und/oder der Detektoranordnung in der Optikeinheit 2 kann selbstverständlich auch vorgesehen sein, diese Komponenten über Lichtleiter mit der Optikeinheit 2 zu verbinden. Andererseits gehört zu den Positionsmesseinrichtungen eine nachfolgend als Maßverkörperungs-Reflektor-Einheit 3 bezeichnete Baueinheit, die am Objekt 1 angeordnet und demzufolge entlang der verschiedenen Achsen x, y, z beweglich gegenüber den anderen Komponenten der Positionsmesseinrichtungen ist. Die Maßverkörperungs-Reflektor-Einheit 3 umfasst wie aus der Draufsicht in Figur 1d ersichtlich mehrere Spuren 3.1 - 3.4, die parallel zueinander entlang der zweiten Hauptbewegungsachse x angeordnet sind. In den Spuren 3.1 - 3.4 sind im dargestellten Ausführungsbeispiel Maßverkörperungen und/oder Messreflektoren angeordnet, auf die die Messstrahlen Mx₁, Mx₂, My₁, My₂, My₃, My₄, Mz₁, Mz₂ der verschiedenen Positionsmesseinrichtungen auftreffen. Als Messreflektor können etwa Planspiegel vorgesehen werden, als Maßverkörperung ein- oder zweidimensionale Beugungsgitter (Auflicht, Durchlicht).

In den Figuren 1a und 1b sind lediglich stark schematisiert die maßgeblichen Messstrahlen Mx₁, Mx₂, My₁, My₂, My₃, My₄, Mz₁, Mz₂ der eingesetzten Positionsmesseinrichtungen angedeutet, die zur Positionserfassung bzw. Positionsbestimmung des Objekts 1 in sechs Freiheitsgraden genutzt werden; auf eine Darstellung der detaillierten Strahlengänge der einzelnen Positionsmesseinrichtungen wurde in diesen Figuren aus Übersichtlichkeitsgründen verzichtet. Insbesondere ist u.a. nicht ersichtlich, dass die verschiedenen Messstrahlen Mx₁, Mx₂, My₁, My₂, My₃, My₄, Mz₁, Mz₂ zweimal in Richtung des Objekts 1 propagieren.

Eine erste Positionsmesseinrichtung ist vorgesehen, um darüber primär die Position des Objekts 1 entlang der ersten Hauptbewegungsachse y bzw. entlang der ersten Messrichtung zu erfassen; ferner erfolgt darüber die Erfassung der Rotationsbewegungen Rx, Rz um die zweite Hauptbewegungsachse x und die dritte Achse z. Zu den erfindungsgemäßen Maßnahmen auf Seiten der ersten Positionsmesseinrichtung sei auf die nachfolgende Beschreibung verwiesen. Die erste Positionsmesseinrichtung ist als Mehrachs-Interferometer mit insgesamt vier Messstrahlen My₁, My₂, My₃, My₄ ausgebildet; in der DE 10 2012 201 393.3 war an dieser Stelle ein 3-Achs-Interferometer mit drei Messstrahlen vorgesehen.

In Bezug auf geeignete optische Positionsmesseinrichtungen zur Erfassung der Bewegung des Objekts 1 entlang der zweiten Messrichtung z bzw. entlang der dritten Messrichtung x sei ausdrücklich auf die bereits eingangs erwähnte DE 10 2012 201 393.3 verwiesen.

So ist in der vorliegenden Anordnung eine zweite Positionsmesseinrichtung vorgesehen, über die Positionssignale bezüglich einer Objektbewegung entlang der zweiten Messrichtung z erzeugbar sind. Diese Positionsmesseinrichtung entspricht im Grunde derjenigen Positionsmesseinrichtung, die in der DE 10 2012 201 393.3 als erste Positionsmesseinrichtung bezeichnet wird. Im Unterschied hierzu sind nunmehr sind anstelle eines einzigen Messstrahls vorliegend zwei Messstrahlen Mz₁, Mz₂ vorgesehen.

Eine dritte Positionsmesseinrichtung dient in der dargestellten Anordnung zur Erzeugung von Positionssignalen bezüglich der Bewegung des Objekts 1 entlang der dritten Messrichtung x. Diese Positionsmesseinrichtung ist analog zu derjenigen Positionsmesseinrichtung aufgebaut, die in der DE 10 2012 201 393.3 als zweite Positionsmesseinrichtung bezeichnet wird. Im Unterschied hierzu ist vorliegend als Maßverkörperung zur Positionsbestimmung entlang der zweiten Hauptbewegungsachse x eine zweidimensionale Maßverkörperung 3.2 vorgesehen, die parallel zur Achse z am ersten Objekt 1 angeordnet ist. Die Messstrahlen der dritten Positionsmesseinrichtung sind in den Figuren mit Mx₁ und Mx₂ bezeichnet.

Im Hinblick auf die Relativanordnung der verschiedenen Messstrahlen Mx₁, Mx₂, My₁, My₂, My₃, My₄, Mz₁, Mz₂ der verschiedenen Positionsmesseinrichtungen sei ferner auf die Figur 1c verwiesen. Diese zeigt eine Frontansicht der Optikeinheit 2 mit den insgesamt acht Messstrahlen Mx₁, Mx₂, My₁, My₂, My₃, My₄, Mz₁, Mz₂ der verschiedenen Positionsmesseinrichtungen

Wie eingangs erwähnt, ist zur hochpräzisen Positionsbestimmung mit Hilfe einer derartigen Anordnung erforderlich, dass die hierbei verwendeten Maßverkörperungen, Messreflektoren und Reflektoren 4.1, 4.2 der verwendeten Positionsmesseinrichtungen einer Selbstkalibration unterzogen werden. Dies erfordert, dass jede genutzte Maßverkörperung, jeder Messreflektor bzw. jeder Reflektor 4.1, 4.2 in den Abtaststrahlengängen der eingesetzten Positionsmesseinrichtungen mittels zweier Optik- bzw. Abtasteinheiten entlang einer einzigen Abtastlinie abgetastet wird, wobei die Abtastlinie jeweils entlang der Erstreckungsrichtung der zu kalibrierenden Komponente verläuft. Hierbei sollte grundsätzlich der erforderliche Aufwand möglichst gering gehalten werden, also insbesondere keine zusätzlichen Optikeinheiten erforderlich werden. Besonders kritisch ist im Fall einer Konfiguration wie in der gezeigten Anordnung die Selbstkalibration der Beugungsgitter 4.1a, 4.1b, 4.2a, 4.2b, die an den Reflektoren 4.1, 4.2 angeordnet sind und u.a. zur hochgenauen optischen Positionserfassung entlang der zweiten Hauptbewegungsachse x und entlang der dritten Achse z über die dritte und zweite Positionsmesseinrichtung dienen. Eine schematisierte Ansicht der Unterseite der Reflektoren 4.1, 4.2 mit den darauf angeordneten Beugungsgittern 4.1 a, 4.1 b, 4.2a, 4.2b ist in Figur 1e gezeigt. Im vorliegenden Ausführungsbeispiel sind diese Beugungsgitter 4.1 a, 4.1 b, 4.2a, 4.2b als Durchlicht-Beugungsgitter ausgebildet, die Oberseite der Reflektoren 4.1, 4.2 ist mit einem Spiegel versehen, dessen reflektierende Seite in Richtung der Durchlicht-Beugungsgitter orientiert ist; die Reflektoren 4.1, 4.2 sind demzufolge jeweils als Durchlichtgitter-Spiegel-Einheit ausgebildet. Zur gewünschten Selbstkalibration dieser Komponenten ist grundsätzlich die Zuschaltung mindestens einer zweiten Optikeinheit bzw. Abtastoptik erforderlich, um aus den erzeugten Positionssignalen der jeweiligen primären Positionsmesseinrichtungen und der Positionssignale der zusätzlichen Optikeinheiten Selbstkalibrationsdaten zu erzeugen.

Erfindungsgemäß ist nunmehr im dargestellten Ausführungsbeispiel vorgesehen, zu diesem Zweck diejenige Positionsmesseinrichtung geeignet zu modifizieren, die zur Positionserfassung des Objekts 1 entlang der ersten Hauptbewegungsachse y bzw. entlang der ersten Messrichtung sowie zur Erfassung der Rotationsbewegungen Rx, Rz um die zweite Hauptbewegungsachse x und die dritte Achse z dient, d.h. die erste Positionsmesseinrichtung. Über die nachfolgend erläuterten Maßnahmen ist es somit möglich, die erste Positionsmesseinrichtung hinsichtlich der damit erfassten Messrichtung definiert umzuschalten, um so jeweils eine zweite Positionsmessung zu Kalibrationszwecken mit Hilfe dieser Positionsmesseinrichtung vorzunehmen. Neben der Positionserfassung entlang der ersten Hauptbewegungsachse y bzw. entlang der ersten Messrichtung ist eine Umschaltung der ersten Positionsmesseinrichtung dahingehend möglich, dass darüber auch eine wahlweise Positionserfassung entlang anderer Messrichtungen möglich wird, nämlich entlang der zweiten Hauptbewegungsachse x und entlang der dritten Achse z.

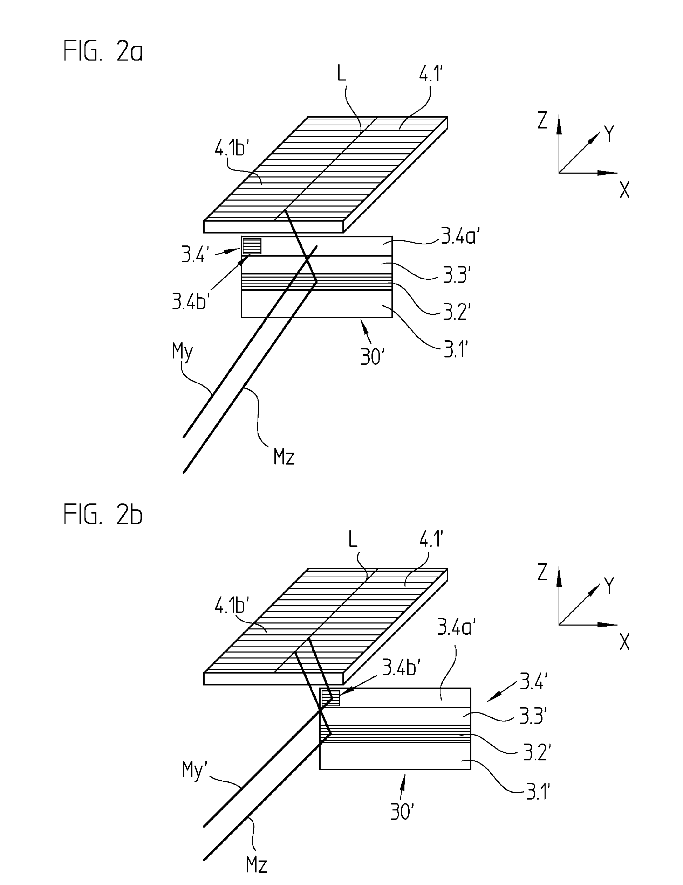

Anhand der stark vereinfachten Darstellungen in den Figuren 2a, 2b wird nachfolgend veranschaulicht, wie eine zweite Abtastung des Reflektors 4.1' bzw. des darauf angeordneten Beugungsgitters 4.1b' entlang von dessen Längserstreckungsrichtung y bzw. entlang der Abtastlinie L über die geeignet modifizierte erste Positionsmesseinrichtung erfolgen kann, um auf diese Art und Weise eine Selbstkalibration des Beugungsgitters 4.1b' zu ermöglichen. Das Beugungsgitter 4.1b' des Reflektors 4.1' dient in der gezeigten Anordnung zur Erzeugung von Positionssignalen bzgl. einer Objektbewegung entlang der dritten Achse z; in der DE 10 2012 201 393.3 wird die hierzu genutzte Positionsmesseinrichtung als erste Positionsmesseinrichtung bezeichnet, in Bezug auf den konkreten Abtaststrahlengang dieser Positionsmesseinrichtung sei ausdrücklich auf die DE 10 2012 201 393.3 verwiesen. Vorliegend ist hierbei von der zweiten Positionsmesseinrichtung die Rede.

Es ist nunmehr erfindungsgemäß vorgesehen, in der Spur 3.4' der Maßverkörperungs-Reflektor-Einheit 30', die primär zur Positionserfassung entlang der ersten Hauptbewegungsachse y dient, mehrere Bereiche 3.4a', 3.4b' bzw. Abschnitte unterschiedlich auszubilden. Ein erster Bereich 3.4a' ist hierbei als Messreflektor in Form eines Planspiegels ausgebildet und dient zur interferometrischen Positionserfassung entlang der ersten Hauptbewegungsachse y. Entscheidend für die gewünschte Messrichtungs-Umschaltbarkeit ist nunmehr die hiervon unterschiedliche Ausbildung mindestens eines zweiten Bereichs 3.4b' in dieser Spur, nämlich als Maßverkörperung in Form eines Auflicht-Beugungsgitters. Die Maßverkörperung ist in diesem zweiten Bereich 3.4b' identisch zu derjenigen Maßverkörperung ausgebildet, die in einer weiteren Spur 3.2' auf der Maßverkörperungs-Reflektor-Einheit 30' angeordnet ist und vom Messstrahl Mz der zweiten Positionsmesseinrichtung für die z-Achsen-Bewegung beaufschlagt wird.

Eine derartige Ausbildung der Bereiche 3.4a', 3.4b' in der Spur 3.4 ermöglicht nunmehr die erfindungsgemäße Umschaltung der Messrichtungen der ersten Positionsmesseinrichtung, wie dies in den Figuren 2a, 2b veranschaulicht wird.

In der Mess- bzw. Maschinenstellung gemäß Figur 2a befindet sich das Objekt und damit die Maßverkörperungs-Reflektoreinheit 30' entlang der zweiten Hauptbewegungsachse x in einer Position, in der der Messstrahl My der ersten Positionsmesseinrichtung auf den Bereich 3.4a' trifft, d.h. auf den beispielsweise als Planspiegel ausgebildeten Messreflektor. Von dort wird der Messstrahl My in Richtung der - nicht dargestellten Optikeinheit zurückreflektiert. In dieser Messstellung arbeitet die erste Positionsmesseinrichtung in bekannter Art und Weise und dient u.a. zur Erfassung der Objekt-Position entlang der ersten Hauptbewegungsachse y. Der in Figur 2a ebenfalls dargestellte Messstrahl Mz der zweiten Positionsmesseinrichtung beaufschlagt in dieser Position die Spur 3.2' mit der dort angeordneten Maßverkörperung sowie das Beugungsgitter des Reflektors 4.1'. Über die zugehörige zweite Positionsmesseinrichtung ist die Erfassung der Objektposition entlang der zweiten Messrichtung bzw. der dritten Achse z möglich.

Verfährt das Objekt bzw. die Maßverkörperungs-Reflektoreinheit 30' entlang der zweiten Hauptbewegungsachse x nunmehr in die Selbstkalibrations-Position für die dritte Achse z, wie dies in Figur 2b gezeigt ist, so trifft der Messstrahl My der ersten Positionsmesseinrichtung dann auf den zweiten Bereich 3.4b' in der entsprechenden Spur 3.4'. Wie ersichtlich, bewirkt die dort angeordnete Maßverkörperung eine Umlenkung des Messstrahls My' analog zur Umlenkung des Messstrahls Mz der zweiten Positionsmesseinrichtung in Richtung des zu kalibrierenden Beugungsgitters 4.1b' auf dem Reflektor 4.1'. Das Beugungsgitter 4.1b' auf dem Reflektor 4.1' wird bei einer resultierenden Objektbewegung entlang der ersten Hauptbewegungsrichtung y nunmehr entlang der Abtastlinie L zweifach abgetastet, d.h. entlang der ersten Hauptbewegungsachse y bzw. entlang der ersten Messrichtung. Eine Selbstkalibration des Beugungsgitters 4.1b' auf dem Reflektor 4.1' ist somit möglich, ohne dass hierzu eine zusätzliche Optik- bzw. Abtasteinheit erforderlich ist. Die erste Positionsmesseinrichtung, die eigentlich primär für die Positionserfassung entlang der ersten Messrichtung respektive der ersten Hauptbewegungsachse y dient, kann in dieser Position derart umgeschaltet werden, dass darüber auch eine Positionserfassung entlang einer anderen Messrichtung, nämlich entlang der dritten Achse z, möglich ist. Zusammen mit den verfügbaren Positionssignalen der für diese Achse z vorgesehenen zweiten Positionsmesseinrichtung ist eine Selbstkalibration der Reflektoren 4.1' entlang ihrer Längserstreckungsrichtung möglich, die der ersten Hauptbewegungsachse y entspricht. Während der Verfahrbewegung entlang der ersten Hauptbewegungsachse y werden die erzeugten Positionssignale der ersten und zweiten Positionsmesseinrichtung einer geeigneten - nicht gezeigten - Kalibrationseinheit zugeführt.

Basierend auf diesem Prinzip können neben den Beugungsgittern 4.1 b, 4.2b auch die Beugungsgitter 4.1a, 4.2a auf den Reflektoren 4.1, 4.2 der Anordnung aus den Figuren 1a - 1e einer Selbstkalibration entlang der ersten Hauptbewegungsrichtung y unterzogen werden. Die Beugungsgitter 4.1a, 4.2a sind in der dritten Positionsmesseinrichtung der vorliegenden Anordnung vorgesehen, über die eine Positionserfassung des Objekts 1 entlang der zweiten Hauptbewegungsachse x erfolgt. Im Hinblick auf den Abtaststrahlengang dieser Positionsmesseinrichtung sei wieder ausdrücklich auf die DE 10 2012 201 393.3, wo diese Positionsmesseinrichtung als zweite Positionsmesseinrichtung bezeichnet wird. Um die erste Positionsmesseinrichtung zur Erfassung der Objektbewegung entlang der ersten Hauptbewegungsachse y auch in diese Messrichtung umzuschalten, umfasst die Maßverkörperungs-Reflektor-Einheit 3 eine weitere Spur 3.1 mit unterschiedlich ausgebildeten Bereichen 3.1a, 3.1 b, wie dies aus Figur 1d ersichtlich ist. Während der Bereich 3.1a als Messreflektor für die Positionserfassung der ersten Positionsmesseinrichtung entlang der ersten Hauptbewegungsachse y ausgebildet ist, sind die Bereiche 3.1b mit einer Maßverkörperung versehen, um in diesen Positionen jeweils eine Ab- bzw. Umlenkung des darauf einfallenden Messstrahls in Richtung der Beugungsgitter 4.1a, 4.2a auf den Reflektoren 4.1, 4.2 zu bewirken und darüber eine zweite Abtastung derselbigen zu ermöglichen, wenn in dieser Stellung eine Objektbewegung entlang der ersten Hauptbewegungsachse y erfolgt. In diesem Fall werden die Positionssignale der umgeschalteten ersten Positionsmesseinrichtung und der dritten Positionsmesseinrichtung einer wiederum nicht dargestellten Kalibrationseinheit zugeführt.

Über die erfindungsgemäßen Maßnahmen ist somit in der beschriebenen Anordnung eine Selbstkalibration von bestimmten Komponenten möglich, ohne dass hierbei zusätzlicher Aufwand auf Seiten der Optik- bzw. Abtasteinheit 2 der eingesetzten Positionsmesseinrichtungen erforderlich ist. Möglich wird dies durch die gezielte Umschaltung der Messrichtung in einer der verwendeten Positionsmesseinrichtungen, im vorliegenden Fall der ersten Positionsmesseinrichtung. Diese kann somit in bestimmten Maschinenstellungen bzw. Kalibrationspositionen für die zur Selbstkalibration erforderliche zweite optische Abtastung der entsprechenden Komponenten und zur Erzeugung entsprechender Positionssignale herangezogen werden.

Wie oben erwähnt, ist die erste Positionsmesseinrichtung in der erläuterten Anordnung als 4-Achs-Interferometer ausgebildet. Darüber ist gewährleistet, dass etwa auch während der erfolgenden Selbstkalibration der Reflektoren entlang der ersten Hauptbewegungsachse y, z.B. mittels eines entsprechend umgelenkten Messstrahls My₁, eine Bestimmung der Position und Orientierung des Objekts über die drei anderen Messstrahlen My₂, My₃ und My₄ möglich ist.

Die gewünschte Messrichtung, entlang der eine Abtastung bzw. Positionserfassung erfolgen soll, wird erfindungsgemäß ausschließlich durch geeignete Modifikationen auf Seiten der Maßverkörperungs-Reflektor-Einheit 3 eingestellt; eine Draufsicht auf diese ist in Figur 1d gezeigt. Auf Seiten der Optikeinheit 2 der ersten Positionsmesseinrichtung sind keine Änderungen erforderlich. In den erfindungsgemäß unterschiedlich ausgebildeten Bereichen 3.4a, 3.4b bzw. 3.1a, 3.1b in den Spuren 3.1, 3.4 der Maßverkörperungs-Reflektor-Einheit 3 erfahren die darauf einfallenden Strahlenbündel der entsprechenden Messstrahlen jeweils unterschiedliche Umlenk- und/oder Ablenkwirkungen. Als vorteilhaft erweist sich, wenn ein erster Bereich 3,1a, 3.4a, der zur Erzeugung der primären Positionssignale der jeweiligen Positionsmesseinrichtung dient, sich über einen Großteil der Spur 3.1, 3.4 erstreckt und der zweite, unterschiedlich ausgebildete Bereich 3.1b, 3.4b, der zur Positionssignalerzeugung im umgeschalteten Betrieb dient, sich lediglich über einen deutlich kleineren Bereich der Spur 3.1, 3.4 erstreckt. So kann wie im obigen Ausführungsbeispiel vorgesehen, der erste Bereich 3,1a, 3.4a zentral in der Spur 3.1, 3.4 angeordnet werden, und lediglich an mindestens einem Ende ein unterschiedlich ausgebildeter zweiter Bereich 3,1b, 3.4b vorgesehen werden, wie dies im dargestellten Ausführungsbeispiel der Maßverkörperungs-Reflektor-Einheit 3 in Figur 1d realisiert ist.

Eine derartige Messrichtungs-Umschaltung, basierend auf den erfindungsgemäßen Überlegungen, kann auch in anderen Anwendungsfällen unabhängig von der diskutierten Selbstkalibrierung zum Einsatz kommen. Beispielsweise kann es vorteilhaft sein, an einer bestimmten Position eines Tisches eine einzelne Messrichtung besonders genau oder aber mit verringertem Abbe-Abstand zu erfassen, um beispielsweise eine Referenzmarke anzutasten. Durch Umschalten einer redundanten Messachse von einer anderen, im sonstigen Betrieb genutzten Messrichtung in die besonders genau zu erfassende Messrichtung lassen sich Positionen entlang dieser Messachse redundant und damit genauer messen.

## Patentansprüche

1. Anordnung mit einer ersten und einer zweiten Positionsmesseinrichtung zur Erfassung der Position eines ersten Objekts (1) in Bezug auf ein zweites Objekt (5), wobei das erste und das zweite Objekt entlang mindestens zweier Messrichtungen (x, y, z) relativ zueinander beweglich angeordnet sind und mit der ersten Positionsmesseinrichtung die Position des ersten Objekts entlang der ersten Messrichtung erfassbar ist und mit der zweiten Positionsmesseinrichtung die Position des ersten Objekts entlang der zweiten Messrichtung erfassbar ist, mit
- einer Optikeinheit (2), die mit einem der beiden Objekte (5) verbunden ist und mindestens eine Lichtquelle, eine Detektoranordnung sowie weitere optische Elemente in definierter Anordnung umfasst und
- einer Maßverkörperungs-Reflektor-Einheit (3, 30'), welche am anderen Objekt (1) angeordnet ist und mindestens zwei unterschiedlich ausgebildete Bereiche (3.1 a, 3.1 b, 3.4a, 3.4b, 3.4a', 3.4b') in einer Spur (3.1, 3.4, 3.4') aufweist, die zur Positionserfassung mit der Optikeinheit (2) optisch abtastbar sind, wobei über die unterschiedliche Ausbildung der Bereiche (3.1a, 3.1b, 3.4a, 3.4b, 3.4a', 3.4b') bei der Positionserfassung eine Umschaltung zwischen den verschiedenen Messrichtungen (x, y, z) möglich ist und für jede Messrichtung (x, y, z) mit der Optikeinheit (2) jeweils Positionssignale bezüglich der Relativbewegung der beiden Objekte (1, 5) erzeugbar sind.

2. Anordnung nach Anspruch 1, wobei in den unterschiedlichen Bereichen (3.1a, 3.1b, 3.4a, 3.4b, 3.4a', 3.4b') der Spur (3.1, 3.4, 3.4') der Maßverkörperungs-Reflektor-Einheit (3, 30') Messreflektoren und Maßverkörperungen angeordnet sind.

3. Anordnung nach Anspruch 2, wobei die Messreflektoren als Planspiegel und die Maßverkörperungen als Auflicht-Beugungsgitter ausgebildet sind.

4. Anordnung nach Anspruch 2, wobei Strahlenbündel, die auf die unterschiedlich ausgebildeten Bereiche (3.1a, 3.1 b, 3.4a, 3.4b, 3.4a', 3.4b') auftreffen unterschiedliche Umlenk- und/oder Ablenkwirkungen erfahren.

5. Anordnung nach Anspruch 1, wobei die Maßverkörperungs-Reflektor-Einheit (3, 30') mehrere parallel angeordnete Spuren (3.1 - 3.4, 3.1' - 3.4') aufweist, in denen Maßverkörperungen und/oder Messreflektoren angeordnet sind.

6. Anordnung nach Anspruch 5, wobei
- in einer Spur (3.2, 3.3, 3.2') eine Maßverkörperung angeordnet ist und
- in einer weiteren Spur (3.1, 3.4, 3.4') in einem ersten Bereich (3.1a, 3.4a, 3.4a') ein Messreflektor angeordnet ist und in einem zweiten Bereich (3.1 b, 3.4b, 3.4b') eine Maßverkörperung angeordnet ist, die identisch zur Maßverkörperung in der anderen Spur (3.2, 3.3, 3.2') ausgebildet ist.

7. Anordnung nach mindestens einem der vorhergehenden Ansprüche, wobei entlang der Erstreckungsrichtung der Spur (3.1, 3.4, 3.4') ein zentraler erster Bereich (3.1 a, 3.4a, 3.4a') in der Spur (3.1, 3.4, 3.4') angeordnet ist und mindestens an einem Ende des ersten Bereichs ein unterschiedlich ausgebildeter zweiter Bereich (3.1 b, 3.4b, 3.4b') in der Spur (3.1, 3.4, 3.4') angeordnet ist.

8. Anordnung nach mindestens einem der vorhergehenden Ansprüche, wobei in der Spur (3.1, 3.4, 3.4') ein erster Bereich (3.1a, 3.4a, 3.4a') angeordnet ist, der sich über den Großteil der Spur (3.1, 3.4, 3.4') erstreckt und ein zweiter, unterschiedlich ausgebildeter Bereich (3.1 b, 3.4b, 3.4b') in der Spur (3.1, 3.4, 3.4') angeordnet ist, der sich lediglich über einen deutlich kleineren Bereich der Spur (3.1, 3.4, 3.4') erstreckt.

9. Anordnung nach einem der vorhergehenden Ansprüche und mit
- einem ersten Objekt (1), das entlang zweier orthogonaler, erster und zweiter Hauptbewegungsachsen (y, x) sowie entlang einer hierzu dritten Achse (z) beweglich angeordnet ist, wobei
- die erste Hauptbewegungsachse (y) als erste Messrichtung fungiert,
- die dritte Achse (z) als zweite Messrichtung und
- die zweite Hauptbewegungsachse (x) als dritte Messrichtung
und
- einem zweiten Objekt (5), das stationär gegenüber dem ersten Objekt angeordnet ist, wobei die Optikeinheit (2) am zweiten Objekt (5) angeordnet ist und wobei
- am ersten Objekt (1) die sich entlang der zweiten Hauptbewegungsachse (x) erstreckende Maßverkörperungs-Reflektor-Einheit (3) angeordnet ist, die eine Spur (3.1, 3.4) mit einem ersten Bereich (3.1 a, 3.4a) mit einem Messreflektor und einen zweiten Bereich (3.1b, 3.4b) mit einer Maßverkörperung umfasst, so dass bei der optischen Abtastung des ersten Bereichs (3.1a, 3.4a) Positionssignale bezüglich einer Bewegung des ersten Objekts (1) entlang der ersten Messrichtung (y) erzeugbar sind und bei der optischen Abtastung des zweiten Bereichs (3.1 b, 3.4b) weitere Positionssignale bezüglich einer Bewegung des ersten Objekts (1) entlang der zweiten Messrichtung (x) oder entlang der dritten Messrichtung (z) erzeugbar sind.

10. Anordnung nach Anspruch 9, die eine dritte Positionsmesseinrichtung umfasst, über die Positionssignale bezüglich einer Bewegung des ersten Objekts (1) entlang der dritten Messrichtung (x) erzeugbar sind.

11. Anordnung nach Anspruch 10 , wobei im Fall der optischen Abtastung der Maßverkörperung im zweiten Bereich und der gleichzeitigen Erzeugung von Positionssignalen mittels der zweiten oder dritten Positionsmesseinrichtung während einer Verfahrbewegung entlang der ersten Messrichtung (y) jeweils eine zweifache Abtastung eines Reflektors (4.1, 4.2) der zweiten oder dritten Positionsmesseinrichtung entlang der ersten Messrichtung (y) erfolgt.

12. Anordnung nach Anspruch 11, wobei
- die Positionssignale der ersten und zweiten Positionsmesseinrichtung einer Kalibrationseinheit zuführbar sind und/oder
- die Positionssignale der ersten und dritten Positionsmesseinrichtung einer Kalibrationseinheit zuführbar sind.

13. Anordnung nach Anspruch 9, wobei die erste Positionsmesseinrichtung als Mehrachs-Interferometer mit vier Messstrahlen (My₁, My₂, My₃, My₄) ausgebildet ist.

## Claims

1. Arrangement with a first and a second position measuring apparatus for registering the position of a first object (1) in relation to a second object (5), wherein the first object and the second object are arranged movably relative to one another along at least two measurement directions (x, y, z) and the position of the first object along the first measurement direction is registrable by means of the first position, measuring apparatus and the position of the first object along the second measurement direction is registrable by means of the second position measuring apparatus, comprising
- an optical unit (2), which is connected to one of the two objects (5) and comprises at least a light source, a detector arrangement and further optical elements in a defined arrangement, and
- a standard/reflector unit (3, 30'), which is arranged at the other object (1) and has at least two differently embodied regions (3.1a, 3.1b, 3.4a, 3.4b, 3.4a', 3.4b') in a track (3.1, 3.4, 3.4'), which, for the purposes of registering the position, can be optically scanned by the optical unit (2), wherein, by way of the different embodiments of the regions (3.1a, 3.1b, 3.4a, 3.4b, 3.4a', 3.4b'), it is possible to switch between the various measurement directions (x, y, z) when registering the position and position signals in respect of the relative movement of the two objects (1, 5) are generable in each case for each measurement direction (x, y, z) by way of the optical unit (2).

2. Arrangement according to Claim 1, wherein measurement reflectors and standards are arranged in the different regions (3.1a, 3.1b, 3.4a, 3.4b, 3.4a', 3.4b') of the track (3.1, 3.4, 3.4') of the standard/reflector unit (3, 30').

3. Arrangement according to Claim 2, wherein the measurement reflectors are embodied as plane mirrors and the standards are embodied as transmitted-light diffraction gratings.

4. Arrangement according to Claim 2, wherein beams which are incident on the differently embodied regions (3.1a, 3.1b, 3.4a, 3.4b, 3.4a', 3.4b') experience different diversion and/or deflection effects.

5. Arrangement according to Claim 1, wherein the standard/reflector unit (3, 30') has a plurality of tracks (3.1-3.4, 3.1'-3.4') arranged in parallel, in which standards and/or measurement reflectors are arranged.

6. Arrangement according to Claim 5, wherein
- a standard is arranged in one track (3.2, 3.3, 3.2') and,
- in a further track (3.1, 3.4, 3.4'), a measurement reflector is arranged in a first region (3.1a, 3.4a, 3.4a') and a standard is arranged in a second region (3.1b, 3.4b, 3.4b'), which standard has an identical embodiment to the standard in the other track (3.2, 3.3, 3.2').

7. Arrangement according to at least one of the preceding claims, wherein, along the direction of extent of the track (3.1, 3.4, 3.4'), a central first region (3.1a, 3.4a, 3.4a') is arranged in the track (3.1, 3.4, 3.4') and a second region (3.1b, 3.4b, 3.4b') with a different embodiment is arranged in the track (3.1, 3.4, 3.4') at least at one end of the first region.

8. Arrangement according to at least one of the preceding claims, wherein a first region (3.1a, 3.4a, 3.4a') is arranged in the track (3.1, 3.4, 3.4'), which first region extends over the majority of the track (3.1, 3.4, 3.4'), and a second region (3.1b, 3.4b, 3.4b') with a different embodiment is arranged in the track (3.1, 3.4, 3.4'), which second region merely extends over a significantly smaller region of the track (3.1, 3.4, 3.4').

9. Arrangement according to one of the preceding claims and comprising
- a first object (1), which is movably arranged along two orthogonal, first and second main movement axes (y, x) and along a third axis (z) in relation thereto, wherein
- the first main movement axis (y) acts as first measurement direction,
- the third axis (z) acts as second measurement direction and
- the second main movement axis (x) acts as third measurement direction,
and
- a second object (5), which is arranged in a stationary manner in relation to the first object, wherein the optical unit (2) is arranged at the second object (5) and wherein
- the standard/reflector unit (3) extending along the second main movement axis (x) is arranged at the first object (1), which standard/reflector unit comprises a track (3.1, 3.4) with a first region (3.1a, 3.4a) with a measurement reflector and a second region (3.1b, 3.4b) with a standard such that, during the optical scanning of the first region (3.1a, 3.4a), position signals are generable in relation to a movement of the first object (1) along the first measurement direction (y) and, during the optical scanning of the second region (3.1b, 3.4b), further position signals are generable in relation to a movement of the first object (1) along the second measurement direction (x) or along the third measurement direction (z).

10. Arrangement according to Claim 9, which comprises a third position measuring apparatus, by means of which position signals in relation to a movement of the first object (1) along the third measurement direction (x) are generable.

11. Arrangement according to Claim 10, wherein, in the case of optical scanning of the standard in the second region and simultaneous generation of position signals by means of the second or third position measuring apparatus during a displacement movement along the first measurement direction (y), there respectively is two-fold scanning of a reflector (4.1, 4.2) of the second or third position measuring apparatus along the first measurement direction (y).

12. Arrangement according to Claim 11, wherein
- the position signals of the first and second position measuring apparatuses are feedable to a calibration unit
and/or
- the position signals of the first and third position measuring apparatuses are feedable to a calibration unit.

13. Arrangement according to Claim 9, wherein the first position measuring apparatus is embodied as a multi-axis Interferometer with four measurement beams (My₁, My₂, My₃, My₄).

## Revendications

1. Agencement avec un premier et un deuxième dispositif de mesure de la position destinés à détecter la position d'un premier objet (1) par rapport à un deuxième objet (5), le premier et le deuxième objet étant disposés en étant mobiles l'un par rapport à l'autre le long d'au moins deux directions de mesure (x, y, z) et la position du premier objet le long de la première direction de mesure étant détectable avec le premier dispositif de mesure de la position, et la position du deuxième objet le long de la deuxième direction de mesure étant détectable avec le deuxième dispositif de mesure de la position, avec
- un ensemble optique (2) qui est relié à l'un des deux objets (5) et qui comprend au moins une source lumineuse, un agencement de détecteurs, ainsi qu'un élément optique supplémentaire selon une disposition définie et
- un ensemble de réflecteurs et mesures matérialisées (3, 30'), lequel est placé sur l'autre objet (1) et comporte au moins deux régions (3.1a, 3.1b, 3.4a, 3.4b, 3.4a', 3.4b') de conception différente dans une voie (3.1, 3.4, 3.4'), qui pour la détection de la position peuvent être balayées optiquement par l'ensemble optique (2), du fait de la conception différente des régions (3.1a, 3.1b, 3.4a, 3.4b, 3.4a', 3.4b'), lors de la détection de la position, une commutation entre les différentes directions de mesure (x, y, z) étant possible et pour chaque direction de mesure (x, y, z), avec l'ensemble optique (2), chaque fois des signaux de position concernant le déplacement relatif des deux objets (1, 5) pouvant être générés.

2. Agencement selon la revendication 1, dans les différentes régions (3.1a, 3.1b, 3.4a, 3.4b, 3.4a', 3.4b') de la voie (3.1, 3.4, 3.4') de l'ensemble de réflecteurs et mesures matérialisées (3, 30') étant placés des réflecteurs de mesure et des mesures matérialisées.

3. Agencement selon la revendication 2, les réflecteurs de mesure étant conçus en tant que miroirs plans et les mesures matérialisées étant conçues en tant que réseaux de diffraction à lumière incidente.

4. Agencement selon la revendication 2, des faisceaux lumineux qui sont incidents sur les régions (3.1a, 3.1b, 3.4a, 3.4b, 3.4a', 3.4b') de conception différente étant soumis à différents effets de déflexion ou de diffraction.

5. Agencement selon la revendication 1, l'ensemble de réflecteurs et mesures matérialisées (3, 30') comportant plusieurs voies (3.1 à 3.4, 3.1' à 3.4') placées de manière parallèle dans lesquelles sont placé(e)s des mesures matérialisées et/ou des réflecteurs de mesure.

6. Agencement selon la revendication 5,
- dans une voie (3.2, 3.3, 3.2') étant placée une mesure matérialisée et
- dans une autre voie (3.1, 3.4, 3.4') dans une première région (3.1a, 3.4a, 3.4a') étant placé un réflecteur de mesure et dans une deuxième région (3.1b, 3.4b, 3.4b') étant placée une mesure matérialisée qui est conçue à l'identique de la mesure matérialisée dans l'autre voie (3.2, 3.3, 3.2').

7. Agencement selon au moins l'une quelconque des revendications précédentes, le long de la direction d'extension de la voie (3.1, 3.4, 3.4'), une première région centrale (3.1a, 3.4a, 3.4a') étant placée dans la voie (3.1, 3.4, 3.4') et au moins sur une extrémité de la première région, une deuxième région (3.1b, 3.4b, 3.4b') de conception différente étant placée dans la voie (3.1, 3.4, 3.4').

8. Agencement selon au moins l'une quelconque des revendications précédentes, dans la voie (3.1, 3.4, 3.4') étant placée une première région (3.1a, 3.4a, 3.4a') qui s'étend sur la majeure partie de la voie (3.1, 3.4, 3.4'), et une deuxième région (3.1b, 3.4b, 3.4b') de conception différente qui s'étend seulement sur une région nettement plus petite de la voie (3.1, 3.4, 3.4') étant placée dans la voie (3.1, 3.4, 3.4').

9. Agencement selon l'une quelconque des revendications précédentes et avec
- un premier objet (1) qui est placé en étant mobile le long de deux axes orthogonaux et d'un premier et un deuxième axe de déplacement principal (y, x), ainsi que le long d'un troisième axe (z), par rapport à ces derniers,
- le premier axe de déplacement principal (y) faisant office de première direction de mesure,
- le troisième axe (z) faisant office de deuxième direction de mesure et
- le deuxième axe de déplacement principal (x) faisant office de troisième direction de mesure
et
- un deuxième objet (5) qui est placé de manière stationnaire par rapport au premier objet, l'ensemble optique (2) étant placé sur le deuxième objet (5) et
- sur le premier objet (1) étant placé l'ensemble de réflecteurs et mesures matérialisées (3) qui s'étend le long du deuxième axe de déplacement principal (x) qui comprend une voie (3.1, 3.4) avec une première région (3.1a, 3.4a) avec un premier réflecteur de mesure et une deuxième région (3.1b, 3.4b) avec une mesure matérialisée, de sorte que lors du balayage optique de la première région (3.1a, 3.4a), des signaux de position concernant un déplacement du premier objet (1) le long de la première direction de mesure (y) peuvent être générés et lors du balayage optique de la deuxième région (3.1b, 3.4b), des signaux de position supplémentaires concernant un déplacement du premier objet (1) le long de la deuxième direction de mesure (x) ou le long de la troisième direction de mesure (z) peuvent être générés.

10. Agencement selon la revendication 9 qui comprend un troisième dispositif de mesure de la position, par l'intermédiaire duquel des signaux de position concernant un déplacement du premier objet (1) le long de la troisième direction de mesure (x) peuvent être générés.

11. Agencement selon la revendication 10, sur lequel, dans le cas du balayage optique de la mesure matérialisée dans la deuxième région et de la génération simultanée de signaux de position au moyen du deuxième ou du troisième dispositif de mesure de la position, pendant un mouvement de déplacement le long de la première direction de mesure (y), il s'effectue chaque fois un double balayage d'un réflecteur (4.1, 4.2) du deuxième ou du troisième dispositif de mesure de la position le long de la première direction de mesure (y).

12. Agencement selon la revendication 11,
- les signaux de position du premier et du deuxième dispositif de mesure de la position pouvant être amenés vers un ensemble de calibrage et/ou
- les signaux de position du premier et du troisième dispositif de mesure de la position pouvant être amenés vers un ensemble de calibrage.

13. Agencement selon la revendication 9, le premier dispositif de mesure de la position étant conçu en tant qu'interféromètre multiaxes avec quatre rayons de mesure (My₁, My₂, My₃, My₄).
